(19) **Europäisches Patentamt / European Patent Office / Office européen des brevets**

(11) **EP 2 144 412 A1**

(12) # EUROPEAN PATENT APPLICATION

(43) Date of publication:
**13.01.2010 Bulletin 2010/02**

(51) Int Cl.:
**H04L 25/02** *(2006.01)*     **H03F 3/45** *(2006.01)*

(21) Application number: **09153897.5**

(22) Date of filing: **27.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **09.07.2008 EP 08160012**

(71) Applicant: **FREESCALE SEMICONDUCTOR, INC. Austin, TX 78735 (US)**

(72) Inventor: **Nascimento, Ivan Carlos Ribeiro 13023-240, Campinas (BR)**

(74) Representative: **Wray, Antony John**
**Freescale Semiconductors,Inc**
**c/o Impetus Limited**
**Grove House**
**Lutyens Close**
**Chineham Court**
**Basingstoke**
**Hampshire RG24 8AG (GB)**

(54) **Differential to single-ended voltage converter**

(57)     An integrated circuit device includes a differential to single-ended voltage converter having multiple current mirrors ([106, 206, 306, 108, 208, 308, 220, 320, 224, 324, 226, 326). Each of the current mirrors is configured to be activated to provide a current or deactivated based on a common mode of a first and second input voltage at the converter. A current based on the combined current generated by the current mirrors is applied to a resistor to generate a single-ended output voltage.

The output voltage represents a difference between the first input voltage and the second input voltage. In addition, one or more of the current mirrors can be configured to be active even when a common mode of the input voltage is outside the supply voltage range for an integrated circuit device. Accordingly, the voltage converter can provide a single-ended voltage representative of the differential input voltage even when a common mode of the input voltage exceeds the supply voltage range.

*FIG. 1*

EP 2 144 412 A1

**Description**

FIELD OF THE DISCLOSURE

The present disclosure relates to voltage converters, and more particularly relates to differential to single-ended voltage converters.

BACKGROUND

Integrated circuit devices sometimes employ a receiver module to receive information communicated via an electrical signal. In some applications, the electrical signal is a differential signal, such that the communicated information is represented by a voltage difference at an input of the receiver. This allows information to be communicated even when a common mode voltage of the information signal is unknown. A voltage converter at the receiver converts the differential voltage at the receive inputs to a single-ended voltage so that the received information is represented as a voltage within the supply voltages of the receiver. However, common mode voltages applied to the differential inputs can be outside the supply voltage range. Resistors can be implemented to attenuate the input voltages to within the supply voltage range so that the differential signal can be converted. However, the differential voltage is also attenuated, resulting in a small differential voltage that can be difficult to differentiate from input noise.

BRIEF DESCRIPTION OF THE DRAWINGS

FIG. 1 illustrates a block diagram of a particular embodiment of an integrated circuit device;

FIG. 2 illustrates a particular embodiment of a circuit diagram of a differential to single-ended voltage converter of FIG. 1;

FIG. 3 illustrates an alternative embodiment of a circuit diagram of the differential to single-ended voltage converter of FIG. 1; and

FIG. 4 illustrates a flow chart of a method for providing a common mode voltage reference in the differential to single-ended voltage converter of FIG. 1.

DETAILED DESCRIPTION

An integrated circuit device includes a differential to single-ended voltage converter having multiple current mirrors. Each of the current mirrors is configured to be activated to provide a current or deactivated based on a common mode of a first and second input voltage at the converter. A current based on the combined current generated by the current mirrors is applied to a resistor to generate a single-ended output voltage. The output voltage represents a difference between the first input voltage and the second input voltage. In addition, one or more of the current mirrors can be configured to be active even when a common mode of the input voltage is outside the supply voltage range for an integrated circuit device. Accordingly, the voltage converter can provide a single-ended voltage representative of the differential input voltage even when a common mode of the input voltage exceeds the supply voltage range.

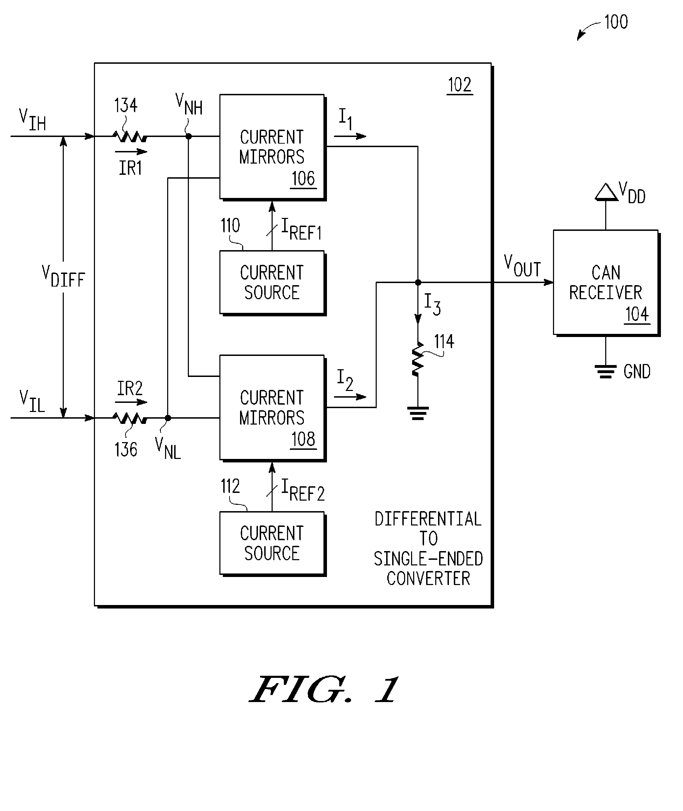

FIG. 1 illustrates a particular embodiment of a block diagram of an integrated circuit device 100 including a differential to single-ended voltage converter 102 and a receiver module 104. The differential to single-ended voltage converter 102 includes a first input terminal, a second input terminal, an output terminal, current mirrors 106 and 108, current sources 110 and 112, and resistors 114, 134, and 136. The first input terminal is configured to receive a first input voltage, labeled $V_{IH}$, and the second input terminal is connected to a second input voltage, labeled $V_{IL}$. The resistor 134 includes a first terminal configured to receive the voltage $V_{IH}$ and a second terminal. The resistor 136 includes a first terminal configured to receive the voltage $V_{IL}$ and a second terminal. The receiver module 104 includes an input terminal connected to the output terminal of the differential to single-ended voltage converter 102, a first reference terminal connected to a first voltage reference, labeled $V_{DD}$, and a second reference terminal connected to a second voltage reference, labeled GND.

The current mirrors 106 have a first input connected to the second terminal of the resistor 134, a second input connected to the second terminal of the resistor 136, a third input, and an output connected to the output terminal of the differential to single-ended voltage converter 102. The current mirrors 108 have a first input connected to the second terminal of the resistor 134, a second input connected to the second terminal of the resistor 136, a third input. The current source 110 has an output connected to the third input of the current mirrors 106. The current source 112 has an output connected to the third input of the current mirrors 108. The resistor 114 has a first terminal connected to the output of the differential to single-ended voltage converter 102, and a second terminal connected to the GND voltage reference.

The receiver module 104 is configured to receive a voltage, labeled $V_{OUT}$, indicative of information communicated by a CAN transmitter (not shown). In an embodiment, the receiver module 104 is configured to be incorporated in an automotive CAN network to receive information communicated by one or more automotive CAN subsystems. In this embodiment, the voltage $V_{OUT}$ represents information communicated by one of the automotive subsystems. In the illustrated embodiment, the voltage $V_{OUT}$ is a single-ended voltage with a magnitude between the voltage references $V_{DD}$ and GND.

The differential to single-ended voltage converter 102 receives the differential input voltage $V_{DIFF}$, representing the difference between $V_{IH}$ and $V_{IL}$. The differential input voltage has an unknown common mode voltage that can be between the supply voltages $V_{DD}$ and GND, above the supply voltage $V_{DD}$, or below the supply voltage GND. The differential to single-ended voltage converter converts the voltage difference $V_{DIFF}$ to a single-ended output voltage $V_{OUT}$ representing the information of the differential input voltage to the receiver module 104.

The current sources 110 and 112 provide currents, labeled $I_{REF1}$ and $I_{REF2}$ respectively, to the differential to single-ended voltage converter 102. The resistor 114 receives a current, labeled $I_3$, and provides an output voltage, labeled $V_{OUT}$, based on the current $I_3$ received and the resistive value $R_{114}$ of the resistor.

The current mirrors 106 and 108 are configured to have a sufficiently high transconductance such that a current through the resistor 134 (labeled $I_{R1}$) is substantially equal to the voltage over the resistor134 ($V_{IH}$ - $V_{NH}$) divided by the resistive value of the resistor 134. Similarly, a current through the resistor 136 (labeled $I_{R2}$) is substantially equal to the voltage over the resistor 136 ($V_{IL}$ - $V_{NL}$) divided by the resistive value of the resistor 136. In addition, the resistive values of the resistors 134 and 136 are configured to be close enough that the voltage $V_{DIFF}$ can be approximated by the following equation:

$$V_{DIFF} = \left( I_{R1} - I_{R2} \right) * R1$$

Thus, the currents $I_{R1}$ and $I_{R2}$ are based on the voltage difference $V_{DIFF}$.

In addition, the voltages $V_{IH}$ and $V_{IL}$ determine whether each of the current mirrors 106 and 108 are in an active state. In particular, the current mirrors 106 are configured to be in an active state in response to both the voltages $V_{IH}$ and $V_{IL}$ being below the voltage $V_{DD}$. In the active state, the current mirrors 106 generate the current $I_1$ based on the current $I_{REF1}$. As one or both of the voltages $V_{IH}$ and $V_{IL}$ approach or exceed the voltage $V_{DD}$, one or more of the current mirrors 106 enter an inactive state, so that the magnitude of the current $I_1$ is set substantially equal to zero.

The current mirrors 108 are configured to be in an active state in response to both the voltages $V_{IH}$ and $V_{IL}$ being above the voltage GND. In the active state, the current mirrors 108 generate the current $I_2$ based on the current $I_{REF1}$. As one or both of the voltages $V_{IH}$ and $V_{IL}$ approach or drop below the voltage GND, one or more of the current mirrors 108 enter an inactive state, so that the magnitude of the current $I_1$ is set substantially equal to zero.

While the input voltage is in a full differential range, such that the common mode voltage of the voltages $V_{IH}$ and $V_{IL}$ is between the supply voltages $V_{DD}$ and GND, each of the current mirrors 106 and 108 are active and produce currents $I_1$ and $I_2$ respectively. The current $I_1$ produced by the current mirror 106 is combined with the current $I_2$ produced by the current mirror 108 to form current $I_3$ which is provided to the resistor 114. Therefore, based on the current $I_1$ of the current mirror 106, the current $I_2$ of the current mirror 108, and the resistive value $R_{114}$ of the resistor 114, the differential to single-ended converter 102 provides the receiver module 104 with the output voltage $V_{OUT}$.

While the common mode input voltage of the voltages $V_{IH}$ and $V_{IL}$ is in a negative range, such that the common mode voltage is below the supply voltage GND, the current mirrors 106 are active and one or more of the current mirrors 108 are not active, so that the current $I_2$ is substantially equal to zero. Thus, for input voltages within the negative range, the current $I_3$ through the resistor 114 is substantially equal to the current $I_1$ produced by the current mirror 106. Therefore, based on the resistive value $R_{114}$ of the resistor 114 and the current $I_1$ from the current mirror 106, the differential to single-ended converter 102 provides an output voltage $V_{OUT}$ to the receiver module 104.

While the common mode input voltage of the voltages $V_{IH}$ and $V_{IL}$ is in a positive range, such that the common mode voltage is above the supply voltage $V_{DD}$, the current mirror 108 is active and one or more of the current mirrors 106 are not active so that the current $I_1$ is substantially equal to zero. Thus, in the positive input voltage range the current $I_3$ in the resistor 114 is substantially equal to the current $I_2$ produced by the current mirror 108. Therefore, based on the resistive value $R_{114}$ of the resistor 114 and the current $I_2$ from the current mirror 108, the differential to single-ended converter 102 provides the output voltage $V_{OUT}$ to the receiver module 104.

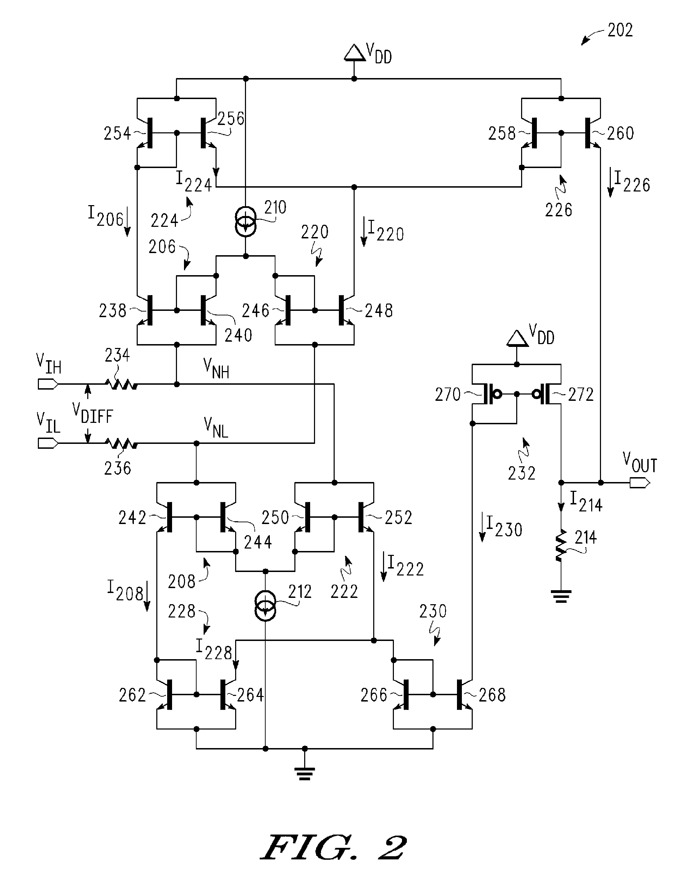

FIG. 2 illustrates a particular embodiment of a differential to single-ended voltage converter 202 including current mirrors 206, 208, 220, 222, 224, 226, 228, 230, and 232, current sources 210 and 212, and resistors 214, 234, and 236. The current mirror 206 includes transistors 238 and 240. The resistor 234 includes a first terminal connected to the first input terminal, and a second terminal connected to the second current electrode of the transistor 238. The resistor 236 includes a first terminal connected to the second input terminal, and a second terminal connected to the first current electrode of the transistor 242. The transistor 238 has a first current electrode, a second current electrode coupled to the second terminal of the resistor234, and a control electrode. The transistor 240 has a first current electrode, a second current electrode connected to the second current electrode of the transistor 238, and a control electrode connected to the first current electrode of the transistor 240 and the control electrode of the transistor 238. The current mirror 208 includes transistors 242 and 244. The transistor 242 has a first current electrode coupled to the second terminal of the resistor 236, a second current electrode, and a control electrode. The transistor 244 has a first current electrode connected to the first current electrode of the transistor 242, a second current electrode connected to the control electrode of the transistor 244 and to the control electrode of the transistor 242.

The current source 210 includes a first terminal connected to a first voltage reference, labeled $V_{DD}$, and a second terminal connected to the first current electrode of the transistor 240. The current source 212 includes a first terminal connected to the second current electrode of the transistor 244, and a second terminal connected to a second voltage reference, labeled GND. The resistor 214 includes a first terminal connected to an output of the differential to single-ended voltage converter 202, and a second terminal connected to the second voltage reference, labeled GND.

The current mirror 220 includes transistors 246 and 248. The transistor 246 has a first current electrode connected to the first current electrode of the transistor 240, a second current electrode coupled to the second terminal of the resistor 236, and a control electrode connected to the first current electrode. The transistor 248 has a first current electrode, a second current electrode connected to the second current electrode of the transistor 246, and a control electrode connected the control electrode of the transistor 246. The current mirror 222 includes transistors 250 and 252. The transistor 250 has a first current electrode coupled to second terminal of the resistor 234, a second current electrode connected to the second current electrode of the transistor 244, and a control electrode connected to the second current electrode. The transistor 252 has a first current electrode connected to the first current electrode of the transistor 250, a second current electrode, and a control electrode connected to the control electrode of the transistor 250.

The current mirror 224 includes transistors 254 and 256. The transistor 254 has a first current electrode connected to the first voltage reference, labeled $V_{DD}$, a second current electrode connected to the first current electrode of the transistor 238, and a control electrode connected to the second current electrode. The transistor 256 has a first current electrode connected to the first current electrode of the transistor 254, a second current electrode, and a control electrode connected to the control electrode of the transistor 254. The current mirror 226 includes transistors 258 and 260. The transistor 258 has a first current electrode coupled to the first current electrode of the transistor 254, a second current electrode connected to the second current electrode of the transistor 256, and a control electrode connected to the second current electrode. The transistor 260 has a first current electrode connected to the first current electrode of the transistor 258, a second current electrode connected to the output, and a control electrode connected to the control electrode of the transistor 258.

The current mirror 228 includes transistors 262 and 264. The transistor 262 has a first current electrode connected to the second current electrode of the transistor 242, a second current electrode connected to the second voltage reference, labeled GND, and a control electrode connected to the first current electrode. The transistor 264 has a first current electrode, a second current electrode connected to the second current electrode of the transistor 262, and a control electrode connected to the control electrode of the transistor 262. The current mirror 230 includes transistors 266 and 268. The transistor 266 has a first current electrode connected to the first current electrode of the transistor 264, a second current electrode connected to the second current electrode of the transistor 264, and a control electrode connected to the first current electrode. The transistor 268 has a first current electrode, a second current electrode connected to the second current electrode of the transistor 266, and a control electrode connected to the control electrode of the transistor 266.

The current mirror 232 includes transistors 270 and 272. The transistor 270 has a first current electrode connected to the first voltage reference, labeled $V_{DD}$, a second current electrode connected to the first current electrode of the transistor 268, and a control electrode connected to the second current electrode. The transistor 272 has a first current electrode connected to the first current electrode of the transistor 270, a second current electrode connected to the output, and a control electrode connected to the control electrode of the transistor 270. The resistor 234 includes a first terminal connected to the first input terminal, and a second terminal connected to the second current electrode of the transistor 238. The resistor 236 includes a first terminal connected to the second input terminal, and a second terminal connected to the first current electrode of the transistor 242.

During operation, a differential voltage including a first input voltage $V_{IH}$ and a second input voltage $V_{IL}$ is applied to the differential to single-ended voltage converter 202. The differential to single-ended voltage converter 102 receives and operates in five different voltage ranges, referred to herein as a full differential range, a positive range, a negative range, a positive extended range, and a negative extended range. The positive range refers to the range whereby the common mode input voltage is above the high supply voltage, labeled $V_{DD}$, but below a positive breakdown voltage limit of the input components. The positive extended range refers to a range whereby the common mode input voltage is above the positive breakdown voltage limit of the input components. The negative range refers to a range whereby the common mode input voltage is below the low supply voltage, labeled GND, but above a negative breakdown voltage limit of the input components. The negative extended range refers to a range whereby the common mode input voltage is below the negative breakdown voltage limit of the voltage converter transistors.

When the input voltage is in the full differential range, all of current mirrors 206, 208, 220, and 222 are active and generate currents $I_{206}$, $I_{208}$, $I_{220}$, and $I_{222}$. A voltage difference $V_{DIFF}$ between the input voltages is determined by subtracting the second input voltage $V_{IL}$ from the first input voltage $V_{IH}$ which is expressed as follows:

$$V_{DIFF} = V_{IH} - V_{IL}$$

The current $I_{234}$ through the resistor 234 is the difference between two times the current $I_{222}$ of the current mirror 222 and two times the current $I_{206}$ of the current mirror 206. Also, the current $I_{236}$ through the resistor 236 is the difference between two times the current $I_{220}$ of the current mirror 220 and two times the current $I_{208}$ of the current mirror 208. Thus, the voltage difference $V_{DIFF}$ can be expressed in terms of the resistive values $R_{234}$ and $R_{236}$ of the resistors 234 and 236 and the currents $I_{206}$, $I_{208}$, $I_{220}$, and $I_{222}$ of the current mirrors 206, 208, 220, and 222. In addition, the transconductance gain of each of the transistors 240, 246, 244, and 250 is configured such that the voltages $V_{NH}$ and $V_{NL}$ are substantially the same. Therefore, the voltage difference $V_{DIFF}$ can be expressed as follows:

$$V_{DIFF} = R_{234} * 2 * (I_{222} - I_{206}) - R_{236} * 2 * (I_{208} - I_{220})$$

In the illustrated embodiment, the resistors 234 and 236 have resistances that are substantially the same. Accordingly, the voltage difference $V_{DIFF}$ can be expressed as follows:

$$(I_{220} - I_{206}) + (I_{222} - I_{208}) = V_{DIFF} / (2* R_{234/236})$$

A current difference between the currents $I_{220}$ and $I_{206}$ results in response to the voltage difference $V_{DIFF}$ between the first input voltage being applied to the current mirror 206 and the second input voltage applied to the current mirror 220. The current mirror 224 generates a current $I_{224}$ equal to the current difference between the current $I_{220}$ and the current $I_{206}$. Additionally, the current mirror 226 generates a current $I_{226}$ that follows the current $I_{224}$, and provides the current $I_{226}$ to the resistor 214. The current $I_{226}$ can be expressed as follows:

$$I_{226} = I_{220} - I_{206}$$

A current difference between the currents $I_{222}$ and $I_{208}$ results in response the voltage difference $V_{DIFF}$ between the first input voltage being applied to the current mirror 222 and the second input voltage applied to the current mirror 208. The current mirror 228 generates a current $I_{208}$ and the resulting current generated by the current mirror 230 is equal to the current difference between the current $I_{222}$ and the current $I_{208}$. Additionally, the current mirror 232 generates a current $I_{232}$ that follows the current $I_{230}$, and provides the current to the resistor 214. The current $I_{232}$ can be expressed as follows:

$$I_{232} = I_{222} - I_{208}$$

The current $I_{226}$ generated by the current mirror 226 is combined with the current $I_{230}$ generated by the current mirror 230 and applied as a current $I_{214}$ to the resistor 214. The current $I_{214}$ can be expressed as follows:

$$I_{214} = (I_{220} - I_{206}) + (I_{222} - I_{208})$$

Combining equations the above equations, the current $I_{214}$ through the resistor 214 can be expressed as follows:

$$I_{214} = V_{DIFF}/(2 * R_{234/236})$$

The output voltage $V_{OUT}$ is equal to the resistive value $R_{214}$ of the resistor 214 multiplied by the current $I_{214}$. Therefore, the output voltage $V_{OUT}$ is product of the voltage difference $V_{DIFF}$ and the resistive value $R_{214}$ divided by the resistive value $R_{234/236}$. The output voltage $V_{OUT}$ can be expressed as follows:

$$V_{OUT} = V_{DIFF} * (R_{214}/ (2 * R_{234/236}))$$

The above equations for VDIFF, I214, and VOUT reflect the behavior of the voltage converter 202 for different input voltage ranges, including the full differential range, positive range, and negative range. For example, when the input voltage is in the positive range, the mirrors 206 and 220 are not active but the mirrors 208 and 222 compensate by increasing the difference of $I_{208}$-$I_{222}$ and therefore $I_{214}$ is constant if VDIFF is kept constant. This results from the transconductance of transistors 240, 246, 244, and 250 being high enough to keep the voltages $V_{NH}$ and $V_{NL}$ the same. In other words: the resistor 234 and 236 are sufficient to cause a voltage difference in $V_{NH}$ to $V_{NL}$ since the change in the base-emitter voltages of the transistors 240, 246, 244, and 250 are very small, and therefore $V_{NH}$ is substantially equal to $V_{NL}$.

When the average input voltage (($V_{IH}$ + $V_{IL}$/2) is above the supply voltage $V_{DD}$ but below breakdown voltage limits of the transistors, the current mirrors 206 and 220 are not active (the currents $I_{206}$ and $I_{220}$ are substantially equal to zero) but the current mirrors 208 and 222 are active. For input voltages within this voltage range, the current mirror 228 also generates the current $I_{228}$ equal to the current difference between the current mirrors 208 and 222. Additionally, the current mirror 230 also generates the current $I_{230}$ that follows the current $I_{228}$ of the current mirror 228, and provides the current $I_{230}$ to the resistor 214. The current mirrors 224 and 226 still operate in this voltage range but do not provide the current $I_{226}$ to the resistor 214 because the currents $I_{206}$ and $I_{220}$ are substantially equal to zero. The current mirrors 224 and 226 continue to operate so that the output voltage $V_{OUT}$ is continually provided even upon a transition between the full differential input voltage range and the positive input voltage range. Thus, the current $I_{214}$ applied to the resistor 214 can be expressed as follows:

$$I_{214} = 0 + (I_{222} - I_{208})$$

In a positive input voltage range, the output voltage $V_{OUT}$ is calculated using the same equation as the full differential voltage range which can be expressed as follows:

$$V_{OUT} = V_{DIFF} * (R_{214}/(2 * R_{234/236}))$$

When the average input voltage is below the supply voltage GND but above breakdown voltage limits of the input components, the current mirrors 208 and 222 are not active (the current currents $I_{208}$ and $I_{222}$ are substantially equal to zero) but the current mirrors 206 and 220 are active. In this negative voltage range, the current mirror 224 generates a current equal to the current difference between the current mirrors 206 and 220. Additionally, the current mirror 226 generates a current that follows the current through the current mirror 224, and provides the current to the resistor 214. The current mirrors 228 and 230 still operate in this voltage range but do not provide a current to the resistor 214 because the current in the current mirrors 208 and 222 is zero. The current mirrors 228 and 230 continue to operate so that the output voltage $V_{OUT}$ is continually provided even upon a transition between the full differential input voltage

range and the negative input voltage range. Thus, only the current $I_{226}$ generated by the current mirror 226 is applied to the resistor 214. The current $I_{214}$ can be expressed as follows:

$$I_{214} = (I_{220} - I_{206}) + 0$$

For the negative input voltage range, the output voltage, at terminal $V_{OUT}$, is calculated using the same equation stated above. Therefore, the output voltage $V_{OUT}$ can be calculated using the same equation for all three input voltage ranges.

$$V_{OUT} = V_{DIFF} * (R_{214}/((2 * R_{234/236}))$$

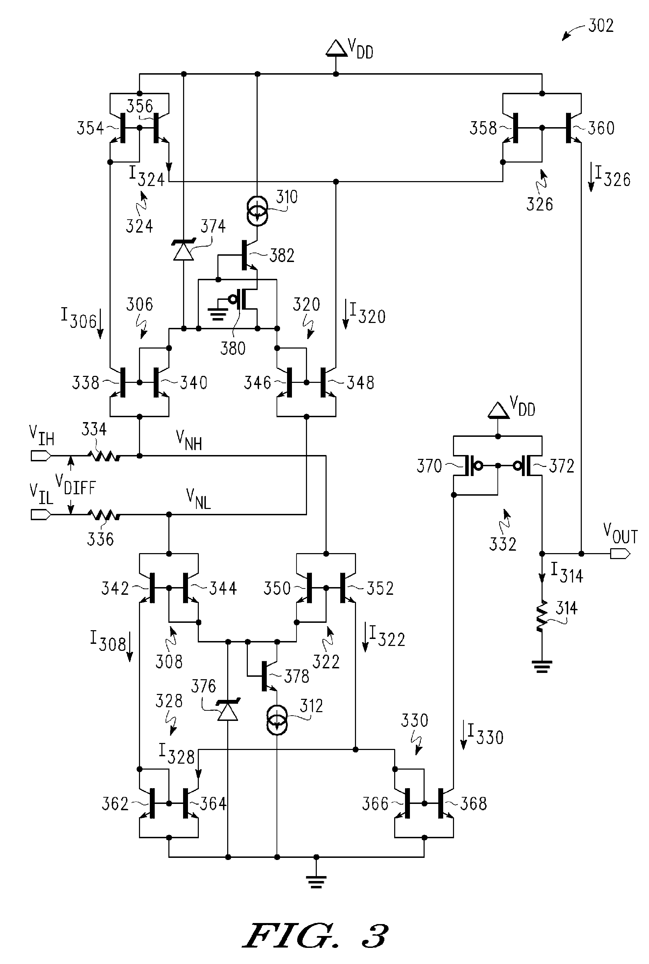

FIG. 3 illustrates an alternative embodiment of a differential to single-ended voltage converter 302 including current mirrors 306, 308, 320, 322, 324, 326, 328, 330, and 332, current sources 310 and 312, resistors 314, 334, and 336, diodes 374 and 376, and transistors 378, 380, and 382. The resistor 334 includes a first terminal connected to the first input terminal and a second terminal connected to the second current electrode of the transistor 338. The resistor 336 includes a first terminal connected to the second input terminal and a second terminal connected to the first current electrode of the transistor 342. The current mirror 306 includes transistors 338 and 340. The transistor 338 has a first current electrode, a second current electrode coupled to the second terminal of resistor 334, and a control electrode. The transistor 340 has a first current electrode, a second current electrode connected to the second current electrode of the transistor 338, and a control electrode connected to the control electrode of the transistor 338. The current mirror 308 includes transistors 342 and 344. The transistor 342 has a first current electrode coupled to a second terminal of resistor 336 a second current electrode, and a control electrode. The transistor 344 has a first current electrode connected to the first current electrode of the transistor 342, a second current electrode, and a control electrode connected to the second current electrode of the transistor 344 and to the control electrode of the transistor 342.

The current source 310 includes a first terminal connected to a first voltage reference, labeled $V_{DD}$, and a second terminal coupled to the first current electrode of the transistor 340. The current source 312 includes a first terminal coupled to the first current electrode of the transistor 344, and a second terminal connected to a second voltage reference, labeled GND. The resistor 314 includes a first terminal connected to an output of the differential to single-ended voltage converter 302, and a second terminal connected to the second voltage reference, labeled GND.

The current mirror 320 includes transistors 346 and 348. The transistor 346 has a first current electrode connected to the first current electrode of the transistor 340, a second current electrode coupled to the second terminal of the resistor 336, and a control electrode connected to control electrode of transistor 340. The transistor 348 has a first current electrode, a second current electrode connected to the second current electrode of the transistor 346, and a control electrode connected the control electrode of the transistor 346. The current mirror 322 includes transistors 350 and 352. The transistor 350 has a first current electrode coupled to the second terminal of resistor 334, a second current electrode connected to the second current electrode of the transistor 344, and a control electrode connected to the second current electrode. The transistor 352 has a first current electrode connected to the first current electrode of the transistor 350, a second current electrode, and a control electrode connected to the control electrode of the transistor 350.

The current mirror 324 includes transistors 354 and 356. The transistor 354 has a first current electrode connected to the first voltage reference, labeled $V_{DD}$, a second current electrode connected to the first current electrode of the transistor 338, and a control electrode connected to the second current electrode. The transistor 356 has a first current electrode connected to the first current electrode of the transistor 354, a second current electrode connected to the first current electrode of the transistor 348, and a control electrode connected to the control electrode of the transistor 354. The current mirror 326 includes transistors 358 and 360. The transistor 358 has a first current electrode coupled to the first current electrode of the transistor 354, a second current electrode connected to the second current electrode of the transistor 356, and a control electrode connected to the second current electrode. The transistor 360 has a first current electrode connected to the first current electrode of the transistor 358, a second current electrode connected to the output, and a control electrode connected to the control electrode of the transistor 358.

The current mirror 328 includes transistors 362 and 364. The transistor 362 has a first current electrode connected to the second current electrode of the transistor 342, a second current electrode connected to the second voltage reference, labeled GND, and a control electrode connected to the first current electrode. The transistor 364 has a first current electrode, a second current electrode connected to the second current electrode of the transistor 362, a second current electrode connected to the voltage reference labeled GND, and a control electrode connected to the control electrode of the transistor 362. The current mirror 330 includes transistors 366 and 368. The transistor 366 has a first current electrode connected to the first current electrode of the transistor 364, a second current electrode connected to the second current electrode of the transistor 364, and a control electrode connected to the first current electrode, and a second current electrode connected to the voltage reference labeled GND. The transistor 368 has a first current electrode, a second current electrode connected to the second current electrode of the transistor 366, and a control electrode connected to the control electrode of the transistor 366.

The current mirror 332 includes transistors 370 and 372. The transistor 370 has a first current electrode connected to the first voltage reference, labeled $V_{DD}$, a second current electrode connected to the first current electrode of the transistor 368, and a control electrode connected to the second current electrode. The transistor 372 has a first current electrode connected to the first current electrode of the transistor 370, a second current electrode connected to the output, and a control electrode connected to the control electrode of the transistor 370.

The diode 374 includes a first terminal connected to the first voltage reference, labeled $V_{DD}$, and a second terminal connected to the control electrode of the transistor 340. The diode 376 includes a first terminal connected to the second current electrode of the transistor 344, and a second terminal connected to the second voltage reference, labeled GND. The transistor 378 includes a first current electrode connected to the second current electrode of the transistor 350, a second current electrode connected to the first terminal of the current source 312, and a control electrode connected to the first current electrode. The transistor 380 includes a first current electrode connected to the first current electrode of transistor 346, a second current electrode connected to the control electrode of the transistor 346, and a control electrode connected to the second voltage reference, labeled GND. The transistor 382 includes a first current electrode connected to the second terminal of the current source 310, a second current electrode connected to the first current electrode of the resistor 380, and a control electrode connected to the second current electrode of the transistor 382.

The differential to single-ended voltage converter 302 operates similarly to the differential to single-ended voltage converter 202 (FIG. 2) within the full differential range, the positive range, and the negative range. Additionally, the diodes 374 and 376 have breakdown voltage chosen to clamp the maximum and minimum voltage values of internal nodes to safe values allowing the differential to single-ended voltage converter 302 to extend the operating range of the voltage converter 302 to accommodate input voltage ranges above the positive breakdown voltage and below the negative breakdown voltage. When the input voltage is above the positive breakdown voltage limit of the input components, the current mirrors 306 and 320 are not active (the currents $I_{306}$ and $I_{320}$ are substantially equal to zero) but the current mirrors 308 and 322 are active. The transistor 382 turns off the current mirrors 306 and 320 in the positive input voltage ranges to allow a seamless transition different the different input voltage ranges. For input voltages within this extended positive voltage range, the current mirror 328 generates a current $I_{328}$ equal to $I_{308}$ current and the input of current mirror 330 will be the difference between the current $I_{322}$ of the current mirror 322 and the current $I_{308}$ of the current mirror 328. Additionally, the current mirror 332 generates a current $I_{332}$ that follows the current $I_{330}$ of the current mirror 330, and provides the current $I_{332}$ to the resistor 314. The current $I_{332}$ can be expressed as follows:

$$I_{332} = I_{322} - I_{308}$$

The current mirrors 324 and 326 still operate in this voltage range but do not provide a current to the resistor 314 because the currents $I_{306}$ and $I_{320}$ in the current mirrors 306 and 320 are substantially equal to zero. Thus, only the current $I_{332}$ generated by the current mirror 332 is applied to the resistor 314. In the extended positive input voltage range, the output voltage, at terminal $V_{OUT}$, is equal to the resistive value $R_{314}$ of the resistor 314 multiplied by the current $I_{332}$ generated by the current mirror 332. In the positive voltage range, the output voltage $V_{OUT}$ can be calculated using the same equation as the other input voltage ranges which can be expressed as follows:

$$V_{OUT} = V_{DIFF} * (R_{314}/((2*R_{334/336}))$$

When the input voltage is below the lower breakdown voltage limit of the input components, the current mirrors 308 and 322 are not active (the currents $I_{308}$ and $I_{322}$ are substantially equal to zero) but the current mirrors 306 and 320 are active. The transistor 378 turns off the current mirrors 308 and 322 in the positive input voltage ranges to allow a seamless transition different the different input voltage ranges. In this extended negative voltage range, the current mirror 324 generates a current equal to $I_{306}$. The current in the input of mirror 326 is the current difference between the current $I_{320}$ of the current mirror 320 and the current $I_{306}$ of the current mirror 306. Additionally, the current mirror 326 generates a current $I_{326}$ that provides the current $I_{326}$ to the resistor 314. The current $I_{326}$ can be expressed as follows:

$$I_{326} = I_{320} - I_{308}$$

The current mirrors 328 and 330 still operate in this voltage range but do not provide currents $I_{328}$ and $I_{330}$ to the resistor 314 because the currents $I_{308}$ and $I_{322}$ of the current mirrors 308 and 322 are substantially equal to zero. Thus, only the current $I_{326}$ generated by the current mirror 326 is applied to the resistor 314. For the extended negative input voltage range, the output voltage, at terminal $V_{OUT}$, is equal to the resistive value $R_{314}$ of the resistor 314 multiplied by the current $I_{326}$ generated by the current mirror 326. Therefore, the output voltage can be calculated using the same equation for all five input voltage ranges, full differential, positive, extended positive, negative, and extended negative which can be expressed as follows:

$$V_{OUT} = V_{DIFF} * (R_{314}/R_{334/336})$$

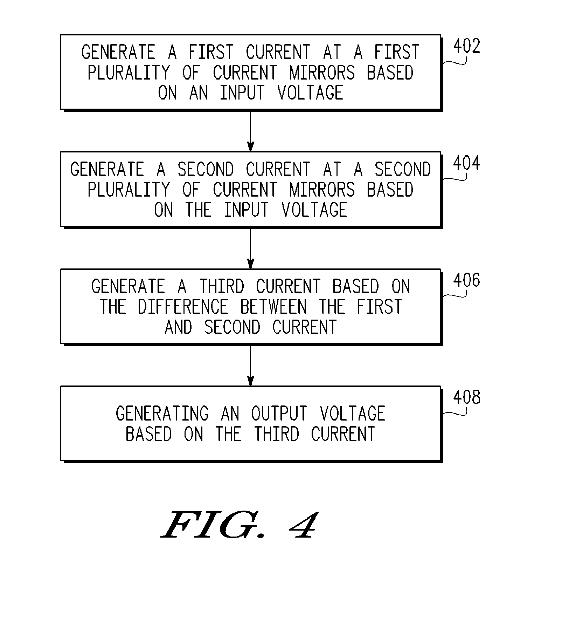

FIG. 4 illustrates a flow diagram of a method 400 for providing a common mode voltage in a differential to single-ended voltage converter. At block 402, a first current based on a differential input voltage is generated at a first plurality of current mirrors. For example, with respect to the voltage converter 202 of FIG. 2, the current mirrors 206, 220, 224, and 226 generate the current $I_{226}$ based on the input voltage $V_{DIFF}$. At block 404, a second current is generated at a second plurality of current mirrors based on the input voltage. For example, with respect to the voltage converter 202, the current mirrors 208, 222, 228, and 230 generate the current $I_{230}$ based on the input voltage $V_{DIFF}$. At block 406, a third current is generated based on a difference between the first current and the second current. For example, with respect to the voltage converter 202, the current $I_{214}$ is generated based on the difference between $I_{226}$ and $I_{230}$. At block 408, an output voltage is generated based on the third current, so that the output voltage is a single-ended representation of the differential input voltage. For example, the voltage converter 202 applies the current $I_{214}$ to the resistor 214 in order to generate the output voltage $V_{OUT}$

Other embodiments, uses, and advantages of the disclosure will be apparent to those skilled in the art from consideration of the specification and practice of the disclosure disclosed herein. The specification and drawings should be considered exemplary only, and the scope of the disclosure is accordingly intended to be limited only by the following claims and equivalents thereof.

## Claims

1. A method comprising:

   generating a first current based on a first plurality of currents at a first plurality of current mirrors (206, 220), the first current based on a difference between a first voltage and a second voltage;
   generating a second current based on a second plurality of currents at a second plurality of current mirrors (208, 222), the second current based on a difference between the first voltage and the second voltage;
   generating a third current based on a difference between the first current and the second current; and
   generating an output voltage based on the third current, the output voltage based on the difference between the first voltage and the second voltage.

2. The method of claim 1 wherein the first current has a substantially zero magnitude when a common mode of the first voltage and the second voltage is above a first supply voltage and a second supply voltage of an integrated circuit device associated with the first plurality of current mirrors, the first supply voltage greater than the second supply voltage.

3. The method of claim 2 wherein the second current has a substantially zero magnitude when a common mode of the first voltage and the second voltage is below a first supply voltage and a second supply voltage of an integrated circuit device associated with the first plurality of current mirrors, the first supply voltage less than the second supply voltage.

4. The method of any of the preceding claims wherein the second current has a substantially zero magnitude when a common mode of the first voltage and the second voltage is below a first supply voltage and a second supply voltage of an integrated circuit device associated with the first plurality of current mirrors, the first supply voltage less than the second supply voltage.

5. The method of any of the preceding claims, wherein generating the first current comprises generating the first current based on a third current generated by a first current source.

6. The method of claim 5, wherein generating the second current comprises generating the second current based on a fourth current generated by a second current source.

7. A device comprising:

a first input terminal (VIH) configured to receive a first input voltage;
a second input terminal (VIL) configured to receive a second input voltage;
a first current mirror (106, 206, 306) configured to generate a first current in response to a common mode voltage of the first input voltage and the second input voltage being within a first specified range;
an output (VOUT) configured to generate an output voltage based on the first current when the common mode voltage is within the first specified range, the voltage representing a difference between the first input voltage and the second input voltage; and
a second current mirror (108, 208, 308) configured to generate a second current in response to the common mode voltage being within a second specified range; and

wherein the output is configured to generate the output voltage based on the second current when the common mode voltage is within the second specified range.

8. The device of claim 7 further comprising:
wherein the first specified range is below a first supply voltage and a second supply voltage of an integrated circuit device coupled to the output of the device, the second supply voltage is less than the first supply voltage.

9. The device of claim 8 wherein the second specified range is above a maximum supply voltage of the receiver.

10. The device of any of claims 7 to 9 further comprising:

a diode (374) configured to enable the first current mirror (106, 206, 306) to generate the first current in response to the common mode voltage being within a third specified range;

wherein the output is further configured to generate the output voltage based on the first current when the common mode voltage is within the third specified range.

11. The device of any of claims 7 to 10 further comprising:

a third current mirror (220, 320) configured to generate a third current in response to the common mode voltage being within the first specified range;

wherein the output (VOUT) is further configured to generate the output voltage based on a difference between the first current and the third current when the common mode voltage is within the first specified range.

12. The device of claim 11 further comprising:

a fourth current mirror (224, 324) configured to generate a fourth current in response to the difference between the first current and the third current;

wherein the output is further configured to generate the output voltage based on the fourth when the common mode voltage is within the first specified range.

13. The device of claim 12 further comprising:

a fifth current mirror (226, 326) configured to generate a fifth current in response to the fourth current;

wherein the output (VOUT) is further configured to generate the output voltage based on the fifth when the common mode voltage is within the first specified range.

14. The device of any of claims 7 to 13 wherein the first current mirror (106, 206, 306) is further configured to generate the first current and the second current mirror (108, 208, 308) is further configured to generate the second current in response to the common mode voltage being within a third specified range, and wherein the output is further configured to generate the output voltage based on the first current and the second current when the common mode voltage is within the third specified range.

15. The device of claim 14 wherein the third specified range is below a first and second supply voltage of a device coupled to the output, the first supply voltage greater than the second supply voltage.

*FIG. 1*

*FIG. 2*

*FIG. 3*

GENERATE A FIRST CURRENT AT A FIRST PLURALITY OF CURRENT MIRRORS BASED ON AN INPUT VOLTAGE — 402

GENERATE A SECOND CURRENT AT A SECOND PLURALITY OF CURRENT MIRRORS BASED ON THE INPUT VOLTAGE — 404

GENERATE A THIRD CURRENT BASED ON THE DIFFERENCE BETWEEN THE FIRST AND SECOND CURRENT — 406

GENERATING AN OUTPUT VOLTAGE BASED ON THE THIRD CURRENT — 408

*FIG. 4*

Europäisches
Patentamt

European
Patent Office

Office européen
des brevets

# EUROPEAN SEARCH REPORT

Application Number

EP 09 15 3897

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 529 078 B1 (GOSSER ROYAL A [US] ET AL) 4 March 2003 (2003-03-04)<br>* column 2, line 16 - line 23 *<br>* column 4, line 44 - line 50 *<br>* column 6, line 20 - line 36 *<br>----- | 1,5-7 | INV.<br>H04L25/02<br>H03F3/45 |
| A | US 2003/076163 A1 (HANGAISHI MAKOTO [JP]) 24 April 2003 (2003-04-24)<br>* paragraphs [0064] - [0067] *<br>----- | 1-15 | |
| A | US 2006/044068 A1 (ALENIN SERGEY [US]) 2 March 2006 (2006-03-02)<br>* abstract *<br>----- | 1-15 | |

TECHNICAL FIELDS
SEARCHED (IPC)

H04L
H03F
H03H

The present search report has been drawn up for all claims

| Place of search | Date of completion of the search | Examiner |
|---|---|---|
| The Hague | 23 November 2009 | De Iulis, M |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

                                     
& : member of the same patent family, corresponding
      document

EPO FORM 1503 03.82 (P04C01)

# EP 2 144 412 A1

## ANNEX TO THE EUROPEAN SEARCH REPORT
## ON EUROPEAN PATENT APPLICATION NO.

EP 09 15 3897

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2009

| Patent document cited in search report | | Publication date | Patent family member(s) | | Publication date |
|---|---|---|---|---|---|
| US 6529078 | B1 | 04-03-2003 | NONE | | |
| US 2003076163 | A1 | 24-04-2003 | JP | 2003101358 A | 04-04-2003 |
| US 2006044068 | A1 | 02-03-2006 | NONE | | |

EPO FORM P0459

For more details about this annex : see Official Journal of the European Patent Office, No. 12/82

17